(19) **Europäisches Patentamt / European Patent Office / Office européen des brevets**

(11) **EP 1 584 518 B1**

(12) **EUROPEAN PATENT SPECIFICATION**

(45) Date of publication and mention
of the grant of the patent:
**17.10.2007 Bulletin 2007/42**

(51) Int Cl.:
*B60R 13/10* (2006.01)    *G02B 5/124* (2006.01)
*G09F 13/04* (2006.01)    *G09F 13/16* (2006.01)
*G09F 13/22* (2006.01)

(21) Application number: **04101449.9**

(22) Date of filing: **07.04.2004**

(54) **License plate assembly comprising light source and backlit license plate**

Kennzeichenschild-Anordnung mit Lichtquelle und hinterleuchtetem Kennzeichenschild

Arrangement de plaque d'immatriculation, avec une source de lumière et une plaque d'immatriculation retro-éclairée

(84) Designated Contracting States:
**AT BE BG CH CY CZ DE DK EE ES FI FR GB GR HU IE IT LI LU MC NL PL PT RO SE SI SK TR**

(43) Date of publication of application:
**12.10.2005 Bulletin 2005/41**

(73) Proprietor: **3M Innovative Properties Company**
**St. Paul, MN 55133-3427 (US)**

(72) Inventors:
• **Prollius, Sven**
  **3M Europe s.a.**
  **B 1831, Diegem (BE)**
• **Reimann, Stefan**
  **3M Europe s.a.**
  **B 1831, Diegem (BE)**
• **Eberwein, Arnold**
  **3M Europe s.a.**
  **B 1831, Diegem (BE)**

(74) Representative: **Voortmans, Gilbert J.L. et al**
  **3M Europe S.A./N.V.**
  **OIPC**
  **Hermeslaan 7**
  **1831 Diegem (BE)**

(56) References cited:
WO-A-20/04048155    DE-A- 10 160 376
DE-A- 10 247 708    DE-U- 20 218 626
DE-U- 20 316 349    US-A- 5 122 902

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

1. Field of the invention.

The present invention relates to a license plate assembly that comprises a light source in front of which is arranged a license plate that comprises a retroreflective sheet. The retroreflective sheet is transparent and comprises on a base prismatic elements. The prismatic elements are truncated and/or contain separation surfaces between them. The present invention further relates to a method of making a retroreflective sheet.

2. Background of the invention.

Commonly employed license plates for motor vehicles for use on roads such as cars, busses and trucks, typically are illuminated from their front face when it is dark. In particular, the license plates typically have indicia representing the license plate number issued by the appropriate national authorities on a retroreflective background. This retroreflectivity enhances visibility of the plate during daytime conditions and also during night time conditions when lights of other motor vehicles or street light impinges upon the front face of the license plate. But in order to meet regulatory requirements, the license plate also needs to be illuminated with lights arranged on the motor vehicles. Thus, typically, lights are arranged aside of the license plate so as to illuminate the front face of the license plate.

Such an arrangement has the disadvantage of limiting the design possibilities of a car manufacturer. In particular, the lights that need to be arranged along one or more sides of the license plate prevent the car manufacturer of making more appealing designs as the lights often appear as a disturbing element in the design. Furthermore, such front-lit license plates may suffer from a non-uniform illumination of the license plate.

To overcome this problem, DE 297 12 954 discloses a license plate arrangement that is illuminated from the back. In particular, this German utility model discloses a stiff transparent plastic plate on which the license plate number is depicted as opaque indicia. The stiff plastic plate is held in front of an electroluminescent foil through a holding frame. The electroluminescent foil when activated illuminates the plastic plate from the back. Such an arrangement has the disadvantage that no retroreflectivity is provided which is a requirement of the regulatory authorities of many countries. A further back-lit license plate is disclosed in US 5,692,327.

EP 1 262 373 describes a back-lit electroluminescent license plate arrangement that also provides retroreflectivity. In particular, this EP application discloses a housing in which there is arranged in the order given (from back to front) an electroluminescent foil, a transparent retroreflective sheet, a roughening layer such as a highly transparent film with a rough surface and a further transparent cover which closes the front opening of the housing such that all layers of the arrangement are held tightly together.

DE 20218626 discloses a backlit license plate in which a retroreflective sheet is adhered to a transparent pane by means of an adhesive layer. It is taught that the use of the adhesive layer prevents optical disturbances, e.g. Newton rings, that would otherwise result from unequal distances between the retroreflective sheet and the transparent pane. .

The indicia of license plates in some countries are provided as raised structures, i.e. by embossing, whereas in other countries, the license plate indicia may be provided by printing, i.e. they are essentially flat. For reasons of cost effectiveness, it would be desirable that essentially the same license plate construction based on similar materials can be used. It has been found that retroreflective sheeting having prismatic elements can be readily used to make license plates having embossed indicia as well as printed indicia. However, when such a retroreflective sheeting is used in the arrangement of DE 20218626, problems arise in that the arrangement becomes sensitive to localised pressure which may result in optical defects in the license plate. Thus, during manufacturing and assembly, the license plate is susceptible to optical defects that create non-uniformity in illumination and/or retroreflection.

Additionally, retroreflective sheeting having prismatic elements is highly retroreflective such that regulatory specifications of retroreflectivity may be far exceeded in some countries although retroreflective sheeting having a reduced retroreflectivity are disclosed in US 5,122,902. But the retroreflective sheeting is typically produced with a replication tool.

As the regulatory specifications may be different from one country to another, different tools may be required for different countries making the license plate expensive to produce.

A license plate assembly according to the preamble of claim 1 is known from DE 10160376 A1.

It would now be desirable to develop a backlit license plate which uses a retroreflective sheeting that can be used with embossed as well as printed indicia. Desirably, the backlit license plate meets the regulatory requirements of retroreflection and backlit illumination. Desirably, the degree of retroreflection and backlit illumination can be obtained in easy and cost effective way and can be readily adapted to various regulatory requirements. Desirably the license plate will have a uniform appearance in retroreflection and illumination and/or has a reduced susceptibility to optical defects that may result from handling or manufacturing of the license plate.

3. Summary of the invention

The present invention provides a license plate assembly according to claim 1.

The reflective sheet used in the license plate should generally be a transparent retroreflective sheet. By the term 'transparent' as used in this application is generally meant that the respective sheet or layer allows sufficient light to pass there through such that a required amount of illumination of the license plate, for example as set by regulatory authorities, can be achieved. Accordingly, transparent materials in connection with the present invention can be optically clear and have a visible light transmission of 80 to almost 100%. The term transparent is however not meant to exclude translucent materials. Translucent materials may have a visible light transmission of only 30 to 80%.

By the term 'transparent retroreflective sheet' is meant that the sheet is capable of retroreflecting light that impinges on the surface of the sheet and is further transparent in the sense set forth above. A transparent retroreflective sheet in accordance with the invention may be highly transparent (transmission for visible light of 80 to 99%) or may be translucent.

In a particular aspect of the invention, the retroreflective sheet comprises truncated prismatic elements.

By the term 'truncated' in relation to prismatic elements is meant that the tops of the prismatic elements have been deformed such that the retroreflective performance of the individual prismatic elements reduces. The resulting truncated surfaces of the prismatic elements may be flat or curved including a displacement of the top of a prismatic element. Truncated prismatic elements include those that can be obtained by heat deforming non-truncated prismatic elements.

License plate assemblies according to the invention may offer such advantages of being less susceptible to optical defects caused during handling and/or manufacturing. Additionally, license plate assemblies may be obtained in an easy and cost effective way meeting a variety of regulatory requirements that may differ from one to another country. Also, the license plate assemblies may generally readily be provided with embossed indicia as well as printed indicia.

4. Brief description of the drawings

The following schematic drawings further illustrate the invention without however the intention to limit the invention thereto.

FIG. 1A is a front view of one embodiment of the retroreflective sheet for use in this invention.
FIG. 1B is a cross section taken along section line 1B--1B of FIG. 1A.
FIG. 1C is a cross section of an embodiment of retroreflective sheet for use in this invention similar to that of FIG. 1B.
FIG. 2A is a front view of a second embodiment of retroreflective sheet for use in this invention.
FIG. 2B is a cross section taken along line 2B--2B of FIG. 2A.
FIG. 3A is a front view of a third embodiment retroreflective sheet for use in this invention.
FIG. 3B is a cross section taken along section line 3B--3B of FIG. 3A.
FIG. 4 is front view of a license plate for use with the invention.
FIG. 5 is a cross-section taken along line A in FIG. 4.
FIG. 6. is license plate assembly according to the invention.
FIG. 7a is photomicrograph of a retroreflective sheeting having prismatic elements that have not been truncated.
FIG. 7b is a photomicrograph of a retroreflective sheeting having truncated prismatic elements obtained by heat deforming a retroreflective sheeting as shown in FIG. 7a.

5. Detailed description of the invention

Retroreflective sheet

The retroreflective sheet for use with this invention comprises on a base a plurality of prismatic elements having lateral faces intersecting the base at base edges. The prismatic elements may be truncated and/or separation surfaces may be provided between the prismatic elements. In particular the separation surfaces are typically bounded by the base edges of the prismatic elements. In a particular embodiment of the present invention, a retroreflective sheet is used as described in US 5,122,902.
Thus, in one particular embodiment, the prismatic elements of the retroreflective sheet are formed by three intersecting sets of parallel grooves, comprising a base, prismatic elements having lateral faces intersecting the base at base edges of a base edge length, and separation surfaces on the base, in which: each set of grooves has a groove side angle that is constant for that set; the separation surfaces are transparent, are bounded by the base edges of the lateral faces of the prismatic elements, and lie between the prismatic elements in at least one of the grooves.

The separation surfaces may be flat or have, taken at any point along any groove in which they lay, curved cross sections taken across that groove. Typically, the separation surfaces have ratios of base edge length to separation surface width, as measured at any point along any groove, which do not exceed 24.7.

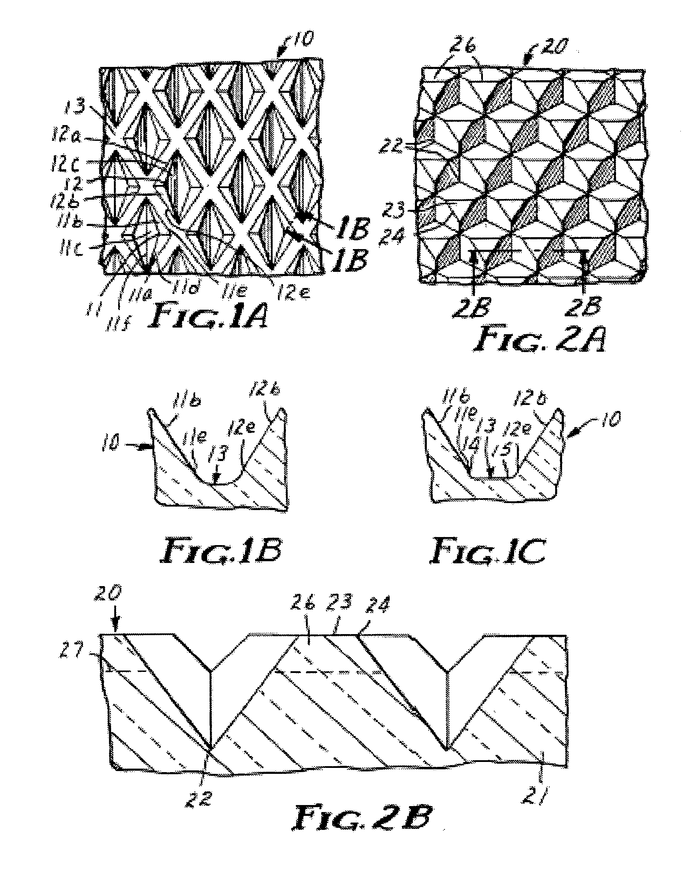

FIGS. 1A and 1B are front and cross sectional views, respectively, of retroreflective sheet 10 that may be used in a license plate assembly in accordance with the invention. Retroreflective sheet 10 comprises several cube-comer elements, of which the elements identified at their corners as 11 and 12 are typical. Element 11 has three triangular lateral faces 11a, 11b, and 11c; and similarly element 12 has faces 12a, 12b, and 12c. Each lateral face has a base edge, e.g., lateral face 11a has base edge 11d. The base of an element is the area enclosed by the three base edges, e.g., the triangle formed by base edges 11d, 11e, and 11f. The bases of elements 11 and 12 may be substantially equilateral triangles, as taught in U.S. Pat. No. 3,712,706 (Stamm). Such an element is also known as a "60-60-60" element in reference to the included angles of the base.

FIG. 1B is a cross sectional view taken across a groove of retroreflective sheet 10, i.e., the view looking down the length of the groove. If the cube-comer elements were packed together as closely as possible, the lateral faces 11b and 12b would meet at a common base edge, or in other words, base edges 11e and 12e would coincide. But in this embodiment, the retroreflective sheet 10 has a separation surface 13, defined for this embodiment as the region lying in the groove between the bases of the elements and bounded by the non-coincident base edges 11e and 12e.

In some embodiments of the invention, the separation surface is flat and thus the cross section taken across the groove (perpendicular to the groove length) is a straight line. Or the separation surface 13 could be curved, and thus the cross section taken across the groove would be a curved line, as in the embodiment shown in FIGS. 1A and 1B. Furthermore, in the embodiment of FIGS. 1A and 1B separation surface 13 is concave (curved away from the apexes of the cube-comer elements), and semi-circular. However, these features of this embodiment are illustrative only. Retroreflective sheets comprising convex separation surfaces are possible embodiments of the invention, as are sheets having separation surfaces in which the cross sections are portions of any smooth curve, not just a portion of a circle.

Furthermore, surfaces having mixed cross sections, comprising both straight and curved portions, could be used. For example, separation surface 13 of FIG. 1C comprises a flat portion 15 between two curved portions 14. In sheets having more than one separation surface, the cross sections of the surfaces may differ from each other in size or cross section, and need not even be the same type. For example, a flat surface may exist across one groove, a surface having a mixed cross section across another groove, and a curved cross section across a third groove.

The retroreflective sheet does not need to have the 60-60-60 cube-comer elements taught by Stamm. Sheets comprising any prismatic retroreflective elements may be used if they are located on a base having separation surfaces as described above. Such elements include those in which the base edges of the lateral faces of the elements substantially form an isosceles triangle in which the unpaired angle measures less than the paired angles. For example, an element could have included angles of substantially 65 degrees, 65 degrees, and 50 degrees.

Or, the lateral faces of the elements may substantially form an isosceles triangle in which the unpaired angle measures more than the paired angles. An example is taught by U.S. Pat. No. 4,588,258 (Hoopman), specifically an element having included base angles of 70 degrees, 55 degrees, and 55 degrees. The Hoopman elements are elements that are rotated 180 degrees. with respect to one another; the three lateral faces of each element are mutually perpendicular and defined at their bases by linear edges that lie in a common plane; and the optical axes of each element of the pair are tilted towards one edge of that element. The optical axis of an element is the trisector of the internal space defined by the faces and base of the element.

In another embodiment, the retroreflective sheet comprises a base and prismatic elements formed on the base in which the elements are truncated prismatic elements, in particular truncated cube-comer elements, having lateral faces, base edges, elevated edges, and truncated surfaces whereby the truncated surfaces are transparent and bounded by the elevated edges of the prismatic elements. The truncated surfaces may be flat or they may be curved.

In the embodiment of FIGS. 2A and 2B, the uppermost parts of some trihedral corners are missing from retroreflective sheet 20, producing truncated full-cube corner elements 26. The imaginary diagonal plane 27 indicates the plane halfway between lower trihedral corners 22 and the (removed) upper trihedral corners. Truncated surfaces 23 lie above imaginary diagonal plane 27 but below the former location of the removed corners. Truncated surfaces 23 are bounded by the elevated edges 24 of truncated full cube corner elements 26.

Truncated surfaces 23 may lie at any perpendicular distance above imaginary diagonal plane 27, but no farther than the missing trihedral corners. Truncated surfaces 23 may also lie below imaginary diagonal plane 27, but no farther than lower trihedral corners 22.

The orientation relative to the imaginary diagonal plane 27 may be reversed, i.e., the unmodified trihedral corners 22 may be above imaginary plane 27 and truncated surfaces 23 below it. In general, the term "elevated edges" means those edges of a truncated full cube-comer element that are displaced from the imaginary plane in the direction of the missing or deformed cube-comer.

This embodiment removes retroreflective portions of the truncated full cube-comer elements, but in samples of the invention prepared in this manner the remaining portions of the elements provided sufficient retroreflectivity for many applications.

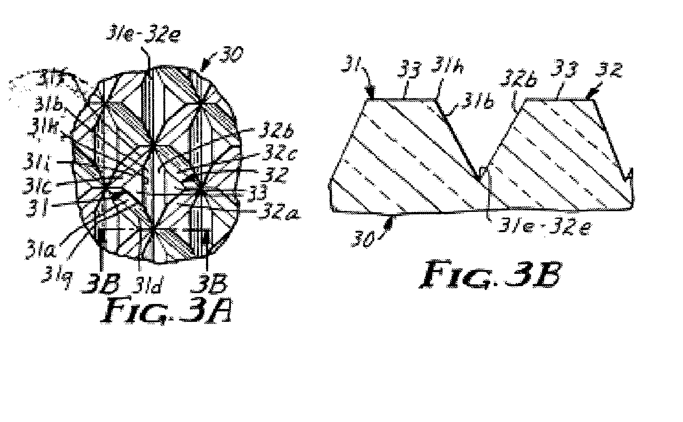

The concept of partial removal of retroreflective elements is not limited to the full cube-comer embodiment. FIGS. 3A and 3B are front and cross sectional views, respectively, of retroreflective sheet 30. Sheet 30 comprises several cube-comer elements according to U.S. Pat. No. 4,588,258 (Hoopman), of which the elements identified as 31 and 32 are typical. Element 31 has three lateral faces 31a, 31b, and 31c; and similarly element 32 has faces 32a, 32b, and 32c. Each lateral face has a base edge and an elevated edge, e.g., lateral face 31b has base edge 31e and elevated edge 31 g. Because the cube-comer elements are packed together as closely as possible, the lateral faces 31b and 32b meet at a common base edge 31e-32e.

In any embodiment incorporating partial removal of cube-comer elements, a retroreflective element is formed by three mutually perpendicular lateral faces from which a cube-comer and adjacent portions of each lateral face are missing. Thus, the retroreflective element is a truncated cube-comer. For example, in the embodiments of FIGS. 3A and 3B, each element has a truncated surface 33 located above the base of the element but below the location where the cube-comer would be if the latter were present. Truncated surface 33 lies above the three base edges 31d-e-f and is bounded by the three elevated edges 31g-h-i of element 31.

In the embodiment shown in FIGS. 3A and 3B, the truncated surface is flat and a triangle because it is parallel to the base of the element, and the base is also a triangle. Thus, the retroreflective element is a frustrum of a triangular pyramid. In general, however, the truncated surface need not be flat, and even if so it need not be parallel to the base of the element. Also, the shape of the truncated surface will vary with the particular element chosen. However, if the truncated surface is flat and parallel to the base of the element it will always be equiangular to the base, but smaller in area.

Any of the cube-comer elements having triangular bases suitable for the embodiments of FIGS. 1A and 2A are also suitable for the embodiments of FIGS. 3A and 3B, including the 60-60-60 design. For the high angularity element taught in U.S. Pat. No. 4,588,258 (Hoopman), the definition of the optical axis of an element is modified to: the trisector of the internal space that would be defined by the faces and base of the element if the faces were extended to form a cube-comer element. If the truncated surface is flat and parallel to the base of the element, i.e., a frustrum of the element, this modified defmition of optical axis is equivalent to: the trisector of the internal space defined by the faces, base, and truncated surface of the element. For purposes of defining an element as taught by Hoopman, the direction of the optical axis is not intended to be changed by the creation of the truncated surface or the modified definition of optical axis.

In a manner similar to the previous embodiments, truncated surfaces having mixed cross sections, comprising both straight and curved portions, could be used, and the particular cross section of a truncated surface need not be constant at every point of the surface.

The retroreflective sheets described in aforementioned embodiments are typically obtained using a tool having a surface appropriate for forming a desired configuration of truncated prismatic elements and/or prismatic elements having between them separation surfaces. Such methods are taught in US 5,122,902.

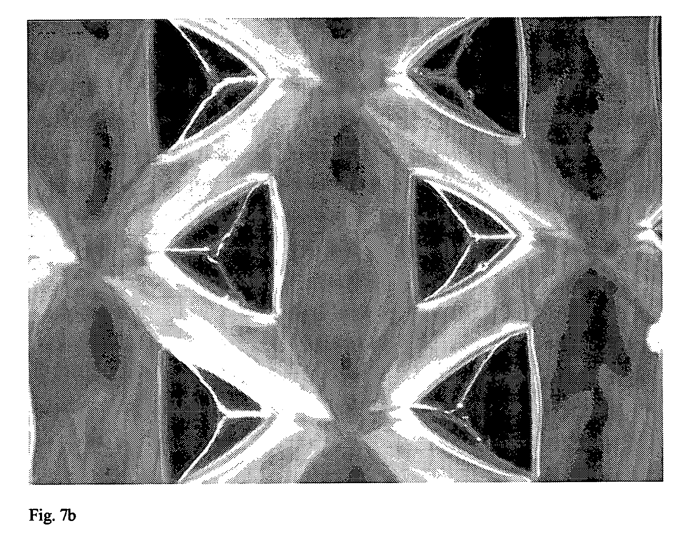

In a particularly preferred embodiment of the present invention, retroreflective sheeting having truncated prismatic elements is made by providing a retroreflective sheet of non-truncated prismatic elements and deforming the tops of the prismatic elements by application of heat and/or pressure. Thus, by the application of heat and/or pressure, the tops of the prismatic elements are deformed such that their optical performance is reduced, i.e. the retroreflectivity of the individual elements is reduced. It has been found that heat and pressure can deform the tops of prismatic elements by flattening them and/or displacing the top of the prismatic element. Generally, the deformation will not result in flat truncated surfaces in the truncated prismatic elements but rather the tops of the prismatic elements may be displaced, e.g. pushed somewhat into the prismatic element. Figure 7b is a photograph of a microscopic view of a cube corner retroreflective sheeting that has been deformed by the application of heat and pressure. The amount of heat and pressure that should be applied depends on the level of retroreflectivity desired as well as on the nature of the retroreflective sheeting. Generally, the material of the prismatic elements of the retroreflective sheeting is thermoplastic material and the prismatic elements may be deformed by heating the thermoplastic material. Typically, the thermoplastic prismatic elements may be heated to a temperature of between 80 and 230°C with a practical range being between 100 and 150°C. The amount of pressure applied will depend on the temperature elected for heating, with generally a lower pressure being needed with a higher temperature. For example, in case pressure is applied by guiding the retroreflective sheeting between two rolls, the line pressure may be between 3 and 30 N/mm, conveniently between 6 and 18 N/mm. Also, the length of time that the retroreflective sheeting is subjected to heat and/or pressure may influence the amount of deformation. Typically, when applying heat and/or pressure by guiding the retroreflective sheeting between two rolls, it may be guided there through at a line speed of for example 0.1 to 2 m/min., typically 0.3 to 1.5 m/min.. Furthermore, although it will generally be preferred to apply heat and pressure, it is also possible to apply either alone. Thus, the prismatic elements, depending on their nature, may be deformed by applying only pressure or by applying only heat.

The prismatic elements may be deformed by heat and pressure by pressing a hot plate against the non-truncated prismatic elements of a retroreflective sheet. Alternatively, the retroflective sheeting may be guided between two rolls, at least one of which is heated so as to apply heat and optional pressure to the non-truncated prismatic elements of the retroreflective sheet.

Suitable materials for the retroreflective sheeting include transparent materials such as glass, acrylics, polycarbonates, polyethylene-based ionomer polymers, polyesters, cellulose acetate butyrate polymers, and polyurethanes. Polycarbonates are generally preferred for their durability and impact resistance, such as would be desirable in a vehicle tail light.

License plate

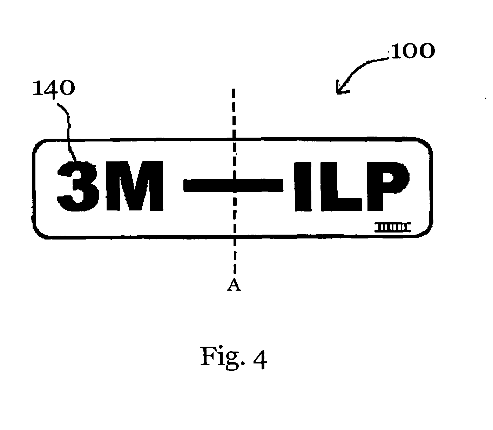

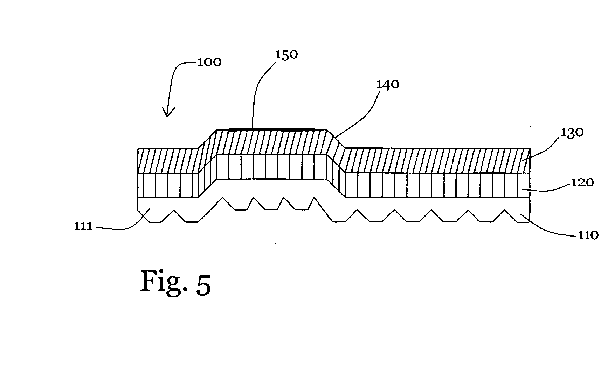

Although it could be contemplated to provide the retroreflective sheeting with the indicia so as to form a license plate, it will generally be preferred that the reflective sheeting be adhered to a transparent polymeric support sheet to obtain a license plate having a desired stiffness. Thus, in a particular embodiment, the license plate comprises a transparent polymeric support sheet and the retroreflective sheet adhered together by a transparent adhesive. The transparent polymeric support sheet is typically bonded to the side of the retroreflective sheet that is opposite to the side that comprises the prismatic elements. A typical embodiment of a license plate in connection with this invention is shown in Figure 4 and 5. Figure 4 shows a front view of a license plate 100 and Figure 5 shows a cross-section along line A in Figure 4. As can be seen from Figure 5, license plate 100 has a retroreflective sheeting 110 that has on a major side of a base truncated prismatic elements 111 and on the opposite of the major side having the prismatic elements, retroreflective sheeting 110 is bonded to transparent polymeric support sheet 130 through adhesive layer 120. The license plate 100 also includes embossed indicia 140 that are rendered opaque or translucent with coating 150.

The transparent polymeric support sheet will typically be a stiff polymeric support sheet. That is, although the transparent polymeric support sheet may be bend somewhat, it has a sufficient stiffness such that it cannot be folded or wrinkled as may be possible with a film or foil. Thus, the support sheet will typically have a thickness to provide such desired stiffness. Typically, the transparent support sheet will have a thickness between 0.2 and 5 mm, preferably between 0.3 and 3 mm and most preferably between 0.5 mm and 1.5 mm. The transparent polymeric support sheet may be comprised of a single polymer layer or may be comprised of several polymer layers of same or different composition.

A layer of the polymeric support sheet may be a thermoplastic polymer layer or may be a cross-linked polymer layer. Also, a combination of thermoplastic polymer layers and cross-linked polymer layers may be used.

Polymeric materials that may be used in the transparent polymeric support sheet include thermoplastic polymers such as polycarbonates, poly(meth)acrylates such as polymethyl methacrylate, polyolefins such as polyethylene and polypropylene, polyesters such as polyethyleneterephthalates and polyethylenenaphthalates, cellulose acetate, polyvinyl chloride and copolymers of acrylonitrile, styrene and butadiene. The transparent polymeric support may further include one or more layers of cross-linked material.

In a preferred embodiment, the transparent polymeric support sheet is cold-formable. By 'cold-formable' in connection with the invention is meant that raised indicia can be formed in the transparent polymeric support sheet at ambient temperature (20 to 35°C) for example through embossing or deep drawing and that such raised indicia are maintained at elevated temperatures to which the license plate may be exposed, e.g. when the motor vehicle is parked in the sun. This typically requires that the polymeric support has a sufficient heat stability, i.e. the polymeric support sheet should typically be heat stable up to temperatures of 60°C to 85°C. Without sufficient heat stability, the number of the license plate may fade over time or become distorted. This will be particularly the case when the indicia are cold-formed through embossing because of stress forces created in the polymeric support sheet during the embossing. Examples of transparent polymeric support sheets that are cold-formable include polymeric support sheets comprising polycarbonate. Also, a polymeric support sheet that is cold-formable may be obtained from a multi-layer construction including one or more thermoplastic polymers enumerated above and one or more layers of a cross-linkable material. Upon cold-forming the indicia in the polymeric support sheet, the cross-linkable material may be cross-linked to a polymeric cross-linked material. Thus, the one or more layers of polymeric cross-linked material will provide the desired heat stability because the cross-linked material will prevent the thermoplastic layers of the multi-layer sheet from flowing, which would cause the cold-formed indicia to disappear. Still further, a cold-formable polymeric support sheet may comprise one or more layers that comprise a cross-linkable thermoplastic polymer composition. In the non cross-linked state, the polymeric support sheet can be readily cold-formed to provide indicia therein. Subsequent to forming the indicia, the cross-linkable thermoplastic polymer composition can be cross-linked such that the layer(s) loses its thermoplastic properties and sufficient heat stability may thereby be provided.

The cross-linkable material that can be used includes materials that may be heat cross-linked, cross-linked by light including visible light and UV light, cross-linked by electron beams or by gamma irradiation. The cross-linkable material may be a composition that is based on cross-linkable monomeric or low molecular weight components, cross-linkable polymer components as well as combinations thereof. Suitable cross-linkable materials that can be used include for example an electron beam curable vinyl chloride-acrylate copolymer as disclosed in US 4,889,895, a radiation curable polyvinyl chloride as disclosed in US 4,631,229, an epoxy based curable composition as described below for use in the adhesive layer.

The transparent polymeric support sheet and the retroreflective sheet may be bonded together with one or more adhesive layers. The term 'bonded together' includes not only a configuration where the support sheet and retro-reflective sheet are directly bonded to each other by the adhesive layer but also includes the option where one or more intermediate layers are present. For example, the retroreflective sheet and/or the polymeric support sheet may be coated with one or more primer layers to assure firm adhesion of the adhesive layer to these respective sheets. Still further, the sheets may be bonded to each other with two or more adhesive layers that are provided on opposite major sides of a transparent carrier layer.

The one or more adhesive layers suitable for bonding the support sheet and retroreflective sheet together should be transparent. Preferably the adhesive layer(s) will be at least 80%, preferably at least 90% transmissive for visible light. The adhesive layers preferably show good weatherability properties, have good thermal stability and are moisture resistant. The adhesive layer should furthermore create a high bond strength to each of the sheets such that the license plate cannot be delaminated. A sufficient bond strength typically means that the peel force necessary to delaminate the sheets from each other is at least 2 N/cm, preferably at least 4 N/cm. The adhesive layer may comprise a pressure sensitive adhesive, a heat-activatable adhesive, i.e. an adhesive that requires heat activation to develop a bond, or a cross-linkable adhesive. Examples of adhesives include pressure sensitive adhesives (PSA) based on acrylic polymers, based on silicones or based on polyolefins as disclosed in Handbook of Pressure Sensitive Adhesive Technology (third edition) D.Satas, Ed. Satas and Associates, Warwick RI/USA, 1989 on pages 444-514, 550-556 and 423-442 respectively. Adhesives that may be used to bond to substrates having a low surface energy such as polyolefin or polycarbonate, include for example pressure sensitive adhesives based on an acrylic copolymer of one or more alkyl esters of acrylic or methacrylic acid and a vinyl ester as disclosed in for example EP 1 318 181 or a pressure sensitive adhesive as disclosed in EP 1 245 656 which discloses a pressure sensitive adhesive composition that contains (i) the reaction product obtainable from a precursor composition comprising one or more alkyl esters of acrylic or methacrylic acid, one or more copolymerizable monomers that have a Lewis base functionality and optionally one or more cross-linkers and (ii) one or more tackifying resins. Still further pressure sensitive adhesives that can be used to create a strong bond in particular to a polycarbonate substrate include those disclosed in US 4,181,752, US 4,418,120 and WO 95/13331. These references teach PSAs that are based on acrylic polymers that are cross-linked without however losing their pressure sensitive adhesive properties. Further adhesive layer compositions that may be used include those that are based on a curable composition that upon curing creates a strong adhesive bond between the sheets. Suitable curable compositions that may be used include radiation curable epoxy compositions. Such compositions may be applied in their uncured (or partially cured) state between the sheets. Upon curing of the laminate through radiation, e.g. UV radiation or electron beam radiation, a firm and durable bond can be created. Examples of epoxy based curable compositions can be found in e.g. EP 1026218 and EP 620 259 disclosing a UV or electron beam curable epoxy composition comprising an epoxy resin, a polyester and optionally a photoinitiator. Still further epoxy-based adhesive compositions are disclosed in US 4,622,349, US 4,812,488, US 4,920,182, US 4,256,828 and EP 276716. Further, according to a particular embodiment of the invention, an epoxy based pressure sensitive thermosetting adhesive can be used as disclosed in US 5,086,088. This US patent discloses a pressure-sensitive thermosetting adhesive comprising from about 30% to about 80% by weight of a photopolymerizable prepolymeric or monomeric syrup containing an acrylic ester and a polar copolymerizable monomer, from about 20% to about 60% by weight of an epoxy resin or a mixture of epoxy resins containing no photopolymerizable groups, from about 0.5% to about 10% by weight of a heat-activatable hardener for the epoxy resin, from about 0.01% to about 5% of a photoinitiator, and from 0% to about 5% of a photocrosslinking agent.

The license plate typically will have shape and dimensions conforming to relevant regulatory requirements. Also, the license plate will comprise indicia that represent the number of the license plate as may be issued by a relevant authority. In addition to indicia representing the number of the license plate, the license plate may comprise further indicia such as for example indicia showing the country letter or indicia giving indications of the manufacturer of the license plate and/or date of issuance of the license plate. Some of these latter indicia may be in machine readable form such as for example in the form of a bar code. The indicia of the license plate can be formed by any technique used in producing license plates. For example, the indicia, in particular those representing the number of the license plate, may be printed e.g. by thermal transfer printing or by ink jet printing or the indicia may be cut out of a colored adhesive film and glued on the plate. The indicia may be printed on or glued on the front face of the license plate or they can be buried in the license plate for example by printing the indicia on the retroreflective sheeting or on the side of the transparent polymeric sheet that is being adhered to the retroreflective sheeting. In addition to printed indicia, the present invention also allows for the indicia to be raised. By raised indicia is meant that the indicia project from the front face of the license plate. Typically the indicia can be raised by 0.3 to 20 mm relative to the background of the license plate, preferably 0.5 to 15 mm. Raised indicia may be obtained by deep drawing but are preferably made by embossing a laminate of the transparent polymeric support sheet and the retroreflective sheet. Preferably the raised surface of the indicia will be colored to render the indicia opaque or at least less transparent than the background of the license plate. Typically the raised surface may be colored by hot foil stamping or by roll coating with inks.

The license plate according to above disclosed embodiments can be made by equipment and techniques that are typically used to produce conventional front lit license plates. Thus, according to one embodiment of the method, the license plate may be obtained by adhering the transparent polymeric support sheet and retroreflective sheet together followed by dimensioning and shaping the obtained laminate as desired. Alternatively however, the respective sheets forming the laminate may be dimensioned and shaped before being adhered together. Also, the license plate may be shaped and dimensioned so as to adapt it for being removably mounted to a light source. For example, a rim may be provided along one or more sides of the license plate. Such a rim may then be used to clamp the license plate against the light source. Alternative, such a rim may locate with one or more corresponding channels on the light source such the license plate may slide into these channels. Still further, portions of the license plate may be projecting beyond the required dimension of the license plate along one or more sides of the license plate and these may then be used to clamp the plate to the light source.

The laminate may be embossed to provide raised indicia. Such embossing is preferably carried out at ambient temperature by pressing a metallic or thermoset polymeric template having a representation of the indicia on the license plate. Following this operation, the raised surfaces of the indicia may be colored by hot stamping a colored wax ribbon thereon. Accordingly, this method allows for making back-lit license plate using the equipment that is typically used to make embossed metallic license plates. Alternatively, the raised indicia may be thermoformed by subjecting the laminate to heat while pressing a template representing the indicia on the laminate.

Back-lit license plates where the indicia are printed by e.g. a thermal transfer printer or inkjet printer can equally be produced with existing manufacturing equipment. For example, such printed license plates are used in the UK. Thus, to produce back-lit license plates that have printed indicia, a laminate of the polymeric support sheet and the retroreflective sheet may be printed on the front face with the indicia. Alternatively, the indicia may be first printed on the retroreflective sheet before it is laminated with the support sheet. Still further, the support sheet, if it defines the front face of the license plate, may be reverse printed before being laminated with the retroreflective sheet. Yet further, an additional transparent film may be included in the laminate which may be provided with the printed indicia. Thus, the same laminate can be used for a variety of existing license plate manufacturing methods.

License plate assembly

The license plate can preferably be removably mounted to a variety of light sources that may be used to provide back lighting. By "removably mounted" is meant that the license plate can be mounted on the light source, removed therefrom and preferably mounted again to the light source. Generally, the mounting of the license plate to the light source is simple and easy and can be practiced by a user or owner of a car. For example, the license plate may be mounted to the light source using screws in much the same way as mounting of conventional license plates. Alternatively, the license plate may be clamped on the light source by means provided on the light source or the license plate may be mounted to the light source through the aid of a frame. The license plate is mounted such that the prismatic elements of the retroreflective sheeting are facing the light sources. The term 'facing' includes both an embodiment where one or more intermediate layers are arranged between the light source and the license plate as well as an embodiment where the retroreflective sheeting and light source are contacting each other.

As mentioned above, the license plate can be used with a variety of light sources that have been used or disclosed for back lighting license plates. For example, the light source may comprise an electrically activatable layer or film that upon electrical activation emits light. Examples thereof include electroluminescent films such as for example those disclosed in WO 98/20375, which describes retroreflective signs such as billboards that are illuminated with an electroluminescent film. Generally, an electroluminescent layer or film will comprise a polymeric binder in which an electroluminescent material is dispersed. Such electroluminescent material may be selected according to a desired color to be emitted and a mixture of different electroluminescent materials can be used. The electroluminescent material is typically an inorganic substance. However, organic electroluminescent materials are known as well and can be used also. Organic electroluminescent materials are known in the art as Organic Light Emitting Diodes (OLED). OLED's typically comprise on a substrate, one or more organic layers between two electrodes. The organic layers can be electrically activated with the electrodes as a result of which they start emitting light. The physical principle on which light is produced by the organic layers is known as "injection electroluminescence". Thus, an organic light emitting diode (OLED) typically comprises an organic light emitting layer disposed between two electrodes, whereby the organic light emitting layer luminesces when electricity flows between the electrodes. OLEDs are described in for example US 6,608,333 and US 6,501,218.

The light source for use in the license plate assembly may also comprise conventional Light Emitting Diodes (LED). According to the invention, the light source comprises a light guide having a front face to which the license plate can be removably mounted, a back face opposite thereto and one or more side faces and (ii) a light source for illuminating the light guide arranged along at least portion of at least one of the side faces, the other side faces generally being closed so as to not to allow light to escape there through. The light source that is used in the edge lighting of the light guide is typically an elongate light source. An elongate light source emits light substantially along its longitudinal direction and comprises an elongated luminant, like a light tube, e.g. a fluorescent tube, or several individual luminants spaced from each other and arranged adjacent to each other along the longitudinal direction of the light source. Accordingly, an elongate light source can comprise a linear array of separate light emitting elements.

Within the light guide, light is transmitted by total internal reflection at the front and back and side faces until the light rays impinge onto the front face and onto the light-transmissive retro-reflective film at an angle at which the light is transmitted out of the front face of the light guide. The light guide may be a hollow or a solid light guide.

The amount of light extracted out of the front face of a light guide can be enhanced by light-scattering particles added to the transparent material of the light guide. Moreover, a back reflector can be arranged at the back face of the light guide. Reflectors can also be arranged at the side faces of the light guide. Both the back reflector and the side face reflectors preferably are diffuse reflective, specular reflective, or scattering reflective films with high reflection efficiency. Arranging reflectors and, in particular, highly diffuser or specular or scattering reflective films along the back and side faces of the light guide provides for a light guide in which light can escape exclusively through the front face so that most of the light of the light source can be used for illuminating the license plate. Accordingly, such a design is highly efficient with regard to the required brightness, even illumination, and power consumption.

Moreover, other light extraction mechanisms, films or paints (in addition to, or as an alternative to, the reflectors mentioned before) can be used with the light guide. Also light-extraction elements printed onto a surface of the light guide (e.g. dots of variable size, shape and density) can be employed. Such arrangements are described, for example, in US-A-5,736,686; 5,649,754; 5,600,462; 5,377,084; 5,363,294; 5,289,351; 5,262,928; 5,667,289; and 3,241,256. Other light extraction arrangements that can be practiced are described in US-A-5,618,096, WO-A-92/05535, and WO-A-01/71248.

The light source of the license plate may be provided as a device that can be removably mounted to the body of the motor vehicle or may be provided as an integral part of the motor vehicle body.

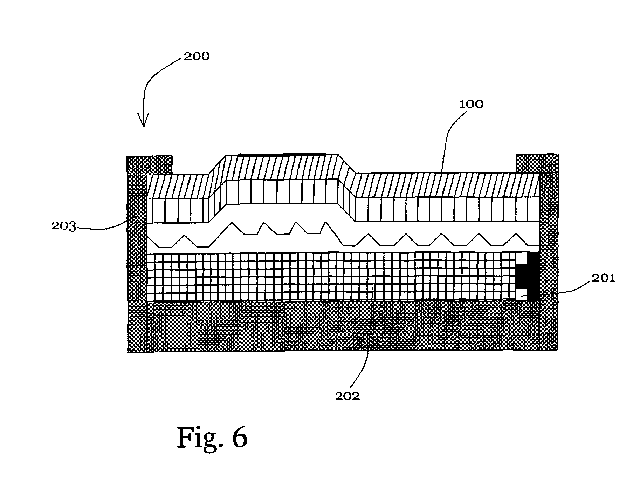

Figure 6 illustrates a license plate assembly in accordance with the invention. License plate assembly 200 comprises a light source that consists of a light guide 202 and an elongated light source 201 lighting the light guide from one of its side faces. On the front face of the light guide is arranged license plate 100. License plate 100 is removably mounted to the light source by clamping it in frame 203 of the license plate assembly 200.

The invention is further illustrated by the following examples without however the intention to limit the invention thereto.

EXAMPLES

Test Methods

Coefficient of Retroreflection, R'

The coefficient of retroreflection, R', was measured using a retroreflectometer commercially available from Delta Light & Optics, Lyngby, Denmark, as model RetroSign 4000.

The reflectometer was placed directly against the retroreflective surface of the sheeting to be evaluated, so that the surface of the sheeting was perpendicular to the light beam. The angle between the normal of the sheeting and the incident light beam was 5° (incident angle). The angle between incident light beam and measurement was 0.33° (observation angle). Test measurements were made according to the procedure described in the instruction manual for the RetroSign instrument. Results were recorded in units of millicandelas / m$^2$ lux.

Each sheeting was evaluated twice, once in the machine direction and once in the cross-web direction, designated as $R'_0$ and $R'_{90}$, respectively.

Example 1

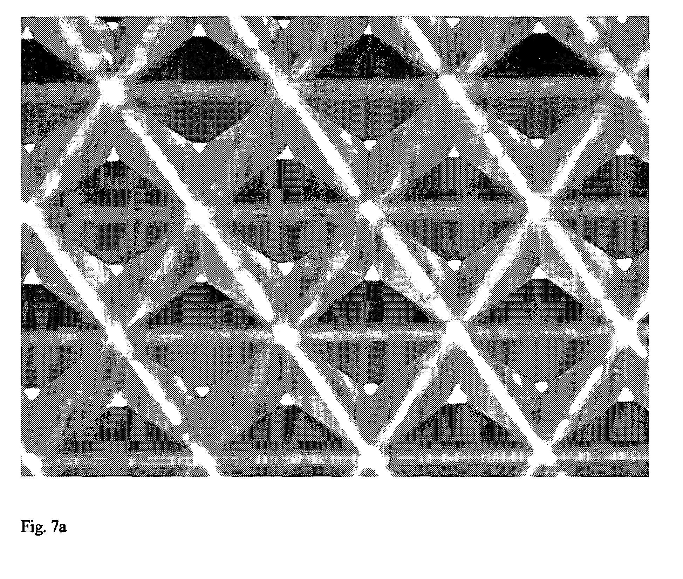

A sheet of retroreflective sheeting having a pattern of cube-corners projecting from one surface was prepared as described in Example 1 of US 6,350,035 with the exception that the optical axis was canted or tilted 8.15 degrees away from the primary groove. The land layer had a thickness of 150 - 160 μm and no body layer film was employed. The sheeting comprised polycarbonate and had a thickness of 237 μm. The sheeting was evaluated for it retroreflective properties using the method described above under Test Methods. Results are summarized in Table 2. A representative photomicrograph of the unmodified sheeting is shown in Figure 7a.

The polycarbonate sheet thus prepared was cut into a section having the dimensions of 16 cm X 10 cm. The sheet was passed through a two-roll laminator (commercially available from Sallmetall B.V., The Netherlands, as MODEL S650 HR-AP). The laminator comprised a heated steel roll and a hard rubber roll. The flat side of the sheeting was removably adhered to an aluminium plate with pressure-sensitive adhesive tape and passed through the laminator with the structured side against the heated steel roll (125°C) at a speed of 1.2 m/min. The pressure of the two rolls was set at a calculated line pressure ($p_L$) of 7.7 N/mm. The line pressure ($p_L$) was calculated by:

line pressure in N/mm = force in N / width of sample in crossweb direction in mm.

Lamination conditions are shown in Table 1.

After heat lamination, the sheet had a thickness of 218 $\mu$m. The sheeting was the evaluated again for it retroreflective properties using the method described above under Test Methods. The sheet had a uniform visual appearance. A photomicrograph of the sheeting of Example 1 is shown in Figure 7b. Results of retroreflectivity measurements are summarized in Table 2.

Example 2

Procedure for Example 1 was repeated with the exception that the sheeting was not adhered on an aluminum plate while passing through the laminator. Lamination conditions are summarized in Table 1. Test results on the sheeting before and after heat lamination are summarized in Table 2.

Example 3

Example 1 was repeated with the exception that the temperature of the heated roll was reduced to 110°C and the speed with which the sheeting was passed through the laminator was reduced to 0.7 m/min. The sheet had a uniform visual appearance. Test results on the sheeting before and after heat lamination are summarized in Table 2.

Comparative Example 1

The microstructured polycarbonate sheeting of Example 1 was embossed with a metal tool having a pattern of hexagons using a plate press. The hexagon tool was pressed onto the microstructured surface with a pressure of 30 bar (4.2 N/mm$^2$) at a temperature of 185° C for 90 seconds. The hexagonal pattern had a cell size of ca 4.4 mm (perpendicular from one side of the hexagon to the other side) and the width of the lines forming the hexagons was ca. 250 $\mu$m. After embossing, the honeycomb hexagonal pattern was visible and the sheeting was not uniform in appearance.

Retroreflectivity measurements were made before and after the embossing. Measurements were made on two areas of the embossed sheet, incorporating varying amounts of embossed area where the microstructure had been completely melted and retroreflectivity was completely absent.

Table 1

| Example | Temp, °C | Line speed, m/min | Line pressure ($p_L$), N/mm | Pressure (p) N/mm$^2$ |
|---|---|---|---|---|
| Ex. 1 | 125 | 1.2 | 7.7 | NA |
| Ex. 2 | 135 | 2.0 | 7.7 | NA |
| Ex. 3 | 110 | 0.7 | 7.7 | NA |
| Comp. Ex. 1 | 185 | NA | NA | 4.2 |
| NA = not applicable | | | | |

Table 2

| Example | R'$_0$, init (cd/ m$^2$ lux) | R'$_{90}$, init (cd/ m$^2$ lux) | R'$_0$, final (cd/ m$^2$ lux) | R'$_{90}$, final (cd/ m$^2$ lux) | Retention R$_0$, % | Retention R$_{90}$, % |
|---|---|---|---|---|---|---|
| Ex. 1 | 927 | 501 | 111 | 100 | 12.0 | 20.0 |
| Ex. 2 | 921 | 844 | 110 | 116 | 11,9 | 13,7 |
| Ex. 3 | 1011 | 549 | 180 | 186 | 17.8 | 33.9 |
| Comp. Ex. 1 | 1090 | 847 | 80 | 99 | 7.3 | 11.7 |
| | 1009 | 873 | 190 | 111 | 18.8 | 12.7 |

**Claims**

1. License plate assembly comprising a light source and a license plate suitable for back illumination, said license plate (100) comprising

   (i) a retroreflective sheet (10 ; 20 ; 30 ; 110) having on a base prismatic elements having lateral faces intersecting the base at base edges, wherein said prismatic elements are truncated having elevated edges and truncated surfaces (23;33) that are transparent and bounded by the elevated edges of the prismatic elements and/or said retroreflective sheet (10) comprises transparent separation surfaces (13) between said prismatic elements (11, 12), said separation surfaces (13) being bounded by the base edges (11e, 12e) of said prismatic elements;
   (ii) and one or more indicia (140);

   and said retroreflective sheet (110) being arranged on said light source (201, 202) such that said prismatic elements of said retroreflective sheet are facing the light source, **characterized in that** said light source is a lighting device comprising (i) a light guide (202) having a front face to which said license plate can be removably mounted, a back face opposite thereto and one or more side faces and (ii) a light source (201) for illuminating said light guide (202) arranged along at least portion of at least one of said side faces.

2. License plate assembly according to claim 1 wherein said truncated prismatic elements are obtainable by heat deforming non-truncated prismatic elements.

3. License plate assembly according to claim 1 wherein said truncated surfaces and/or said separation surfaces are flat.

4. License plate assembly according to claim 1 wherein said truncated surfaces and/or said separation surfaces are curved.

5. License plate assembly according to any of the previous claims wherein said indicia comprise raised structures.

6. License plate assembly according to any of the previous claims wherein said indicia are opaque or have a reduced transparency relative to background areas of the license plate.

7. License plate assembly according to any of the previous claims wherein said license plate comprises a laminate of said retroreflective sheet and a transparent polymeric support sheet, said transparent polymeric support sheet being adhered to the side of said retroreflective sheet that is opposite to the side containing said prismatic elements through one or more transparent adhesive layers.

8. License plate assembly according to claim 7 wherein said indicia are obtainable by embossing said laminate.


**Patentansprüche**

1. Kennzeichenschild-Anordnung, eine Lichtquelle und ein für Hinterleuchtung geeignetes Kennzeichenschild aufweisend, wobei das Kennzeichenschild (100) aufweist

   (i) eine rückstrahlende Folie (10; 20; 30; 110), die auf einer Grundfläche prismatische Elemente aufweist, die seitliche Flächen aufweisen, die die Grundfläche an Grundflächenkanten kreuzen, wobei die prismatischen Elemente abgestumpft sind und erhöhte Kanten und abgestumpfte Flächen (23; 33), welche durchsichtig sind und durch die erhöhten Kanten der prismatischen Elemente eingegrenzt sind, aufweisen, und/oder die rückstrahlende Folie (10) durchsichtige Trennflächen (13) zwischen den prismatischen Elementen (11, 12) aufweist, wobei die Trennflächen (13) durch die Grundflächenkanten (11e, 12e) der prismatischen Elemente eingegrenzt sind;
   (ii) und ein oder mehrere Kennzeichen (140);

   und wobei die rückstrahlende Folie (110) auf der Lichtquelle (201, 202) derart angeordnet ist, dass die prismatischen Elemente der rückstrahlenden Folie der Lichtquelle zugewandt sind, **dadurch gekennzeichnet, dass** die Lichtquelle eine Beleuchtungsvorrichtung ist, aufweisend (i) einen Lichtleiter (202), der eine Vorderfläche, an welche das Kennzeichenschild abnehmbar befestigt werden kann, eine dazu gegenüberliegende Rückfläche und eine oder mehrere Seitenflächen aufweist, und (ii) eine Lichtquelle (201) zum Beleuchten des Lichtleiters (202), die entlang von mindestens einem Teil von mindestens einer der Seitenflächen angeordnet ist.

2. Kennzeichenschild-Anordnung nach Anspruch 1, wobei die abgestumpften, prismatischen Elemente durch Wärmeverformen von nicht-abgestumpften, prismatischen Elementen erhaltbar sind.

3. Kennzeichenschild-Anordnung nach Anspruch 1, wobei die abgestumpften Flächen und/oder die Trennungsflächen flach sind.

4. Kennzeichenschild-Anordnung nach Anspruch 1, wobei die abgestumpften Flächen und/oder die Trennungsflächen gekrümmt sind.

5. Kennzeichenschild-Anordnung nach einem der vorhergehenden Ansprüche, wobei die Kennzeichen erhöhte Strukturen aufweisen.

6. Kennzeichenschild-Anordnung nach einem der vorhergehenden Ansprüche, wobei die Kennzeichen undurchsichtig sind oder eine reduzierte Durchsichtigkeit relativ zu Hintergrundbereichen des Kennzeichenschilds aufweisen.

7. Kennzeichenschild-Anordnung nach einem der vorhergehenden Ansprüche, wobei das Kennzeichenschild einen Verbund aus der rückstrahlenden Folie und einer durchsichtigen, polymeren Stützfolie aufweist, wobei die durchsichtige, polymere Stützfolie durch eine oder mehrere durchsichtige Klebeschichten auf derjenigen Seite der rückstrahlenden Folie angeklebt ist, die der Seite gegenüberliegt, die die prismatischen Elemente enthält.

8. Kennzeichenschild-Anordnung nach Anspruch 7, wobei die Kennzeichen durch Prägen des Verbunds erhaltbar sind.

**Revendications**

1. Ensemble de plaque d'immatriculation, qui comprend une source de lumière et une plaque d'immatriculation adaptée pour être éclairée par l'arrière, ladite plaque d'immatriculation (100) comprenant :

(i) une feuille rétroréfléchissante (10; 20; 30; 110) qui présente sur une base des éléments prismatiques dont des faces latérales coupent la base sur des bords de la base, lesdits éléments prismatiques étant tronqués, présentant des bords relevés et des surfaces tronquées (23; 33) transparentes et reliées par les bords relevés des éléments prismatiques et/ou ladite feuille rétroréfléchissante (10) comprenant des surfaces transparentes de séparation (13) entre lesdits éléments prismatiques (11, 12), lesdites surfaces de séparation (13) étant reliées par les bords de base (11e, 12e) desdits éléments prismatiques,
(ii) un ou plusieurs caractères alphanumériques (140) et

ladite feuille rétroréfléchissante (110) étant placée sur ladite source de lumière (201, 202) de manière à ce que lesdits éléments prismatiques de ladite feuille rétroréfléchissante fassent face à la source de lumière, **caractérisé en ce que** ladite source de lumière est un dispositif d'éclairage comprenant (i) un dispositif (202) de guidage de lumière qui présente une face avant sur laquelle ladite plaque d'immatriculation peut être montée de manière libérable, une face arrière qui lui est opposée et une ou plusieurs faces latérales et (ii) une source de lumière (201) qui éclaire ledit dispositif (202) de guidage de lumière et qui est placée le long d'au moins une partie d'au moins une desdites faces latérales.

2. Ensemble de plaque d'immatriculation selon la revendication 1, dans lequel lesdits éléments prismatiques tronqués peuvent être obtenus en chauffant des éléments prismatiques non tronqués afin de les déformer.

3. Ensemble de plaque d'immatriculation selon la revendication 1, dans lequel lesdites surfaces tronquées et/ou lesdites surfaces de séparation sont planes.

4. Ensemble de plaque d'immatriculation selon la revendication 1, dans lequel lesdites surfaces tronquées et/ou lesdites surfaces de séparation sont courbes.

5. Ensemble de plaque d'immatriculation selon l'une quelconque des revendications précédentes, dans lequel lesdits caractères alphanumériques comprennent des structures surélevées.

6. Ensemble de plaque d'immatriculation selon l'une quelconque des revendications précédentes, dans lequel lesdits caractères alphanumériques sont opaques ou présentent une transparence plus faible que celle des zones d'arrière-plan de la plaque d'immatriculation.

7. Ensemble de plaque d'immatriculation selon l'une quelconque des revendications précédentes, dans lequel ladite plaque d'immatriculation comprend un stratifié constitué de ladite feuille rétroréfléchissante et d'une feuille de support en polymère transparent, ladite feuille de support en polymère transparent étant collée à l'aide d'une ou plusieurs couches adhésives transparentes sur le côté de ladite feuille rétroréfléchissante qui est opposé au côté qui contient lesdits éléments prismatiques.

8. Ensemble de plaque d'immatriculation selon la revendication 1, dans lequel ledit code d'immatriculation est obtenu par emboutissage dudit stratifié.

FIG.1A

FIG. 2A

FIG.1B

FIG.1C

FIG.2B

FIG. 3A

FIG. 3B

Fig. 4

Fig. 5

Fig. 6

Fig. 7a

Fig. 7b

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 29712954
- US 5692327 A
- EP 1262373 A
- DE 20218626
- US 5122902 A
- DE 10160376 A1
- US 3712706 A, Stamm
- US 4588258 A, Hoopman
- US 4889895 A
- US 4631229 A
- EP 1318181 A
- EP 1245656 A
- US 4181752 A
- US 4418120 A
- WO 9513331 A
- EP 1026218 A
- EP 620259 A
- US 4622349 A
- US 4812488 A
- US 4920182 A
- US 4256828 A
- EP 276716 A
- US 5086088 A
- WO 9820375 A
- US 6608333 B
- US 6501218 B
- US 5736686 A
- US 5649754 A
- US 5600462 A
- US 5377084 A
- US 5363294 A
- US 5289351 A
- US 5262928 A
- US 5667289 A
- US 3241256 A
- US 5618096 A
- WO 9205535 A
- WO 0171248 A
- US 6350035 B

**Non-patent literature cited in the description**

- Handbook of Pressure Sensitive Adhesive Technology. Satas and Associates, 1989, 444-514550-556423-442